# EUROPEAN PATENT APPLICATION

(11) **EP 0 705 913 A1**
(43) Date of publication of application: **10.04.1996**
(21) Application number: 95113378.4
(22) Date of filing: 25.08.1995
(51) Int. Cl.: C23C 16/16, C23C 16/00

(54) **Method for manufacturing plastic forming dies**

(30) Priority: 26.08.1994 JP 201827/94; 21.07.1995 JP 185812/95
(71) Applicant: KABUSHIKI KAISHA KYOKUTOU GIKEN, Nagoya-shi, Aichi-ken (JP)
(72) Inventor: Kitano, Minoru c/o Kabushiki Kaisha Kyokutou Giken, Nagoya-shi Aichi-ken (JP)
(74) Representative: Strasser, Wolfgang, Dipl.-Phys

(57) **Abstract**

The mandrel surface (28) is heated to the metal carbonyl's deposition temperature and by introducing vapor on the mandrel surface a metallic layer (40) is formed. The metal's deposition from metal carbonyl vapor is done evenly regardless of whether the mandrel shape is irregular, so that few modification or adjustment is needed after metal deposition layer is completed. Separation of the metallic coating from the mandrel is accomplished when the surface of the mandrel comprised of alloy Al or Al is formed by a heat resistant resin layer, the metal layer deposited by this method is easily peeled burning off the heat resistant resin after the metal carbonyl's metallic layer is formed.

## Description

### BACKGROUND OF THE INVENTION

### Field of the Invention

This invention relates to a method of manufacturing plastic forming dies using a mandrel (master model).

### Description of the Related Arts

Past method of manufacturing plastic forming dies with complicated irregular shapes, which are used for plastic injection formation or foaming, used electroforming. Namely, first of all a plastic mandrel is made with desired shape and the conductivity of a metallic layer made by an electroless deposition on the surface of the plastic mandrel. Then, a thick metal layer of copper, nickel, or silver formed on this conductive layer by electro deposition and, the metallic skin is peeled from the plastic mandrel through electroforming.

In past method of manufacturing plastic forming dies form electroforming, an electro-deposition layer formed by electro-plating means that it took time for the electro-plating layer to grow. Because of this, a long time was needed to get a forming die with the desired thickness. For example, the formation speed of an electro-deposition layer of nickel from electro-plating is 0.001 inch per hour.

Furthermore, it was easy for the electric current to be directed at the tip because the electroplating properties make it difficult for the electric current to flow in the concave part. So, the electro-deposition layer became uneven and thick at the convex part. Because of that, additional time was needed to make modifications to the plastic forming die after the electro-deposition layer is completed.

Also, in past manufacturing methods of plastic forming dies from electroforming, it was impossible to thicken an electro-deposition layer at a desired place. Furthermore, when a direct back up metal is cast for the electro-deposition layer, it is easy to peel the electro-deposition layer an back up metal.

### SUMMARY OF THE INVENTION

This invention proposes a manufacturing method for plastic forming dies to resolve the above problems in plastic forming die manufacturing methods from electroforming, to complete the manufacture of plastic forming dies in a short time, and reduce the work for modifications to the plastic forming die after it is finished. It is also the purpose of this invention to propose a manufacturing method for plastic forming dies which can thicken a shell at a desired, specific place and in which the electro-deposition and back up metal will not peel.

The mandrel surface is heated to the metal carbonyl's deposition temperature and by introducing vapor on the mandrel surface a metallic layer is formed. The metal's deposition rate from the metal carbonyl vapor is remarkably higher than the rate from electroforming. Compared to electroforming with the same metal thickness, this is 10 times faster and the productivity is remarkably higher. Also, the metal's deposition from metal carbonyl vapor is done evenly regardless of whether the mandrel shape is irregular, so that few modification or adjustment is needed after metal deposition layer is completed. Furthermore, separation is easy when the surface of the mandrel comprised of alloy Al or Al is formed by a heat resistant resin layer, the metal layer deposited by this method is easily peeled burning off the heat resistant resin after the metal carbonyl's metallic layer is formed.

### BRIEF DESCRIPTION OF THE DRAWING

Fig. 1 shows an outline diagram of the apparatus used in the examples.

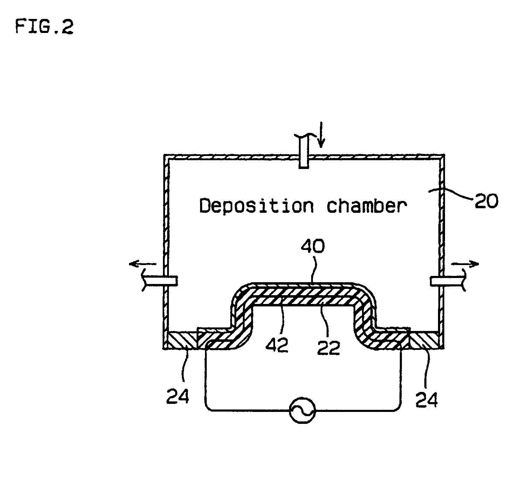

Fig. 2 is a cross section view of the deposition chamber used by the mandrel in the example.

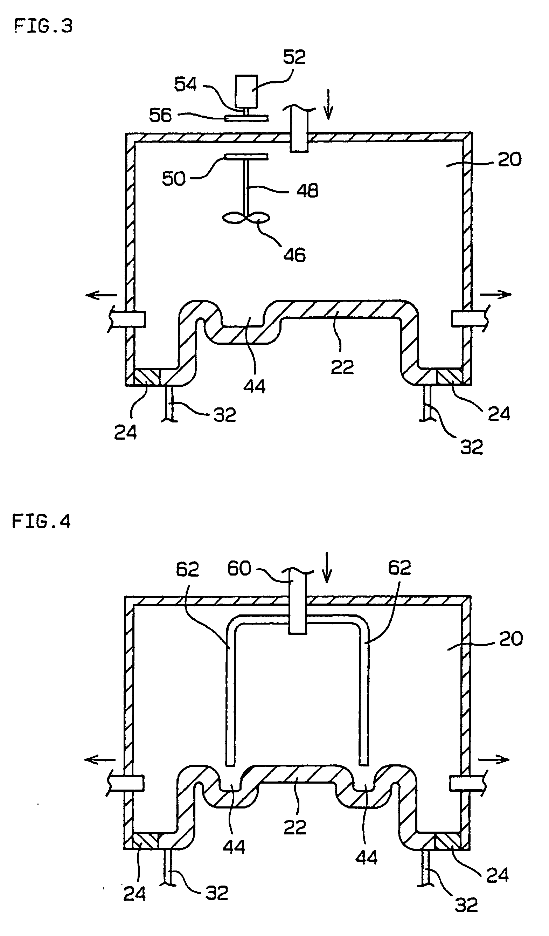

Fig. 3 is a cross section view of the deposition chamber in the example of claim 11.

Fig. 4 is a cross section view of the deposition chamber in the example of claim 12.

### DETAILED DESCRIPTION OF THE PREFERRED EMBODIMENT

In the manufacturing method of this invention for plastic forming dies, a mandrel is affixed to a surface in a sealed deposition chamber and the surface of the mandrel is heated to the metal carbonyl's deposition temperature. The metallic layer forms on the surface of the mandrel by introducing metal carbonyl inside the deposition chamber. The metal carbonyl can use either a Ni, Co, Ta or W carbonyl.

In the manufacturing method of this invention for plastic forming dies, a heat resistant resin layer is formed on the mandrel surface comprising alloy Al or Al and heated oil in the heating method circulates in a pipe imbedded inside alloy Al or Al. A heating lamp can also be placed in back of alloy Al or Al in this heating method. In the manufacturing method of this invention for plastic forming dies, a heat resistant layer is employed for the mandrel and heat can also be added with an electric wire imbedded in the heat resistant resin layer.

Furthermore, in Claim 1 of the manufacturing method of this invention for plastic forming dies, a ventilation means is employed to supply metal carbonyl vapors directly at a specific part of the mandrel. Then, the mandrel is adhered to the surface in the sealed deposition chamber and the surface of the mandrel is heated to the metal carbonyl's deposition temperature. After a metal layer forms on the surface of the mandrel by introducing metal carbonyl inside the deposition chamber, a sprayed metal coating is made on the reverse side of the metal layer and the back up metal is cast on it directly.

In the manufacturing method of this invention for plastic forming dies, the mandrel surface is heated to the metal carbonyl's deposition temperature and the metal carbonyl vapor degrades the mandrel surface by introducing a metal carbonyl vapor on the mandrel surface where a metallic layer is formed. The metal's deposition rate from the metal carbonyl vapor is remarkably higher than the rate from electroforming. For example, the Ni carbonyl deposition rate is 0.01 inches per hour so that compared to electro-forming this invention is 10 times faster and the productivity is remarkably higher. Also, metal deposition from metal carbonyl vapor is done evenly regardless of whether the mandrel shape is irregular so there is no need to make additional modifications after the plastic forming die is complete.

In this invention, we can use as the mandrel material such materials that is resistant to heat at the metal carbonyl's deposition temperature and that can easily peel off from the deposited metal layer even if it is metal or it is resin. For example, as stated in Claim 3, when the surface of the mandrel comprising alloy Al or Al forms a heat resistant layer, and if the heat resistant resin layer is burnt off after the metal carbonyl's metallic layer is formed, then separation can be done easily. Also, the Al or Al alloys which comprise the metal wick of the mandrel can be reused.

Heat from the oil directly warming the back of the mandrel may be blown or the back of the mandrel may be illuminated by a warming lamp on alloy Al or Al which comprise the mandrel's metal wick. Warm oil circulates in a heating pipe imbedded inside alloy Al or Al and the surface of the mandrel is evenly heated so that a uniform metal layer forms. Furthermore, when the mandrel is comprised of a heat resistant resin layer, then the same effect can be obtained by burying on electrical wire in the heat resistant resin layer.

In this invention's manufacturing method for plastic forming dies, the desired thickness of a specific part of a metal layer's thickness can be formed from the metal carbonyl vapor supplied by a blowing means directly at a specific part of the mandrel. Also, after the metallic spray coating forms on the back of the metal layer. The sprayed metal coating is interposed as an internal chill back up metal so the back up metal and the deposition metal layer remain stuck and will not peel.

Claims 3 through 5 of the present invention purport that the heat resistant temperature of the heat resistant resin layer is under 150 degrees Celsius. Even if an epoxy resin (a functional group of 2 epoxy resins) with a heat resistant temperature of under 150 degrees Celsius is substituted for an epoxy resin (a functional group of more than 3 epoxy resins) with a heat resistant temperature of 150 to 250 degrees Celsius for the heat resistant temperature layer, there is a metal wick for heating as a back up comprising the Al or Al alloys so even when the heat resistant resin layer heats to the heat decomposition temperature of nickel carbonyl (148-191 degrees Celsius), because of the complex combination metal wick used for heating there is no warping and after the metal deposition and peeling is very easy to do.

The invention in Claim 11 for the blowing means in Claim 9 purports that a rotation motor be set outside the deposition chamber and a ventilation blade set inside the deposition chamber at a specific place which is rotated by the rotation motor. The invention in Claim 12 purports that the ventilation means is supplied with carbonyl vapor by a vapor branch pipe from a vapor supply pipe.

### Example 1

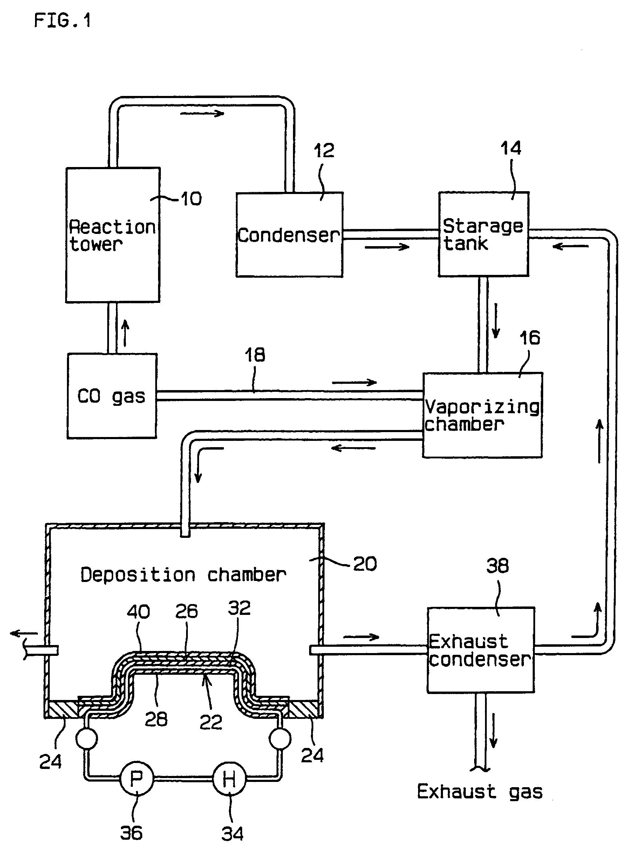

The benefits of this invention are clear from the description of the invention's examples. Figure 1 shows a simple diagram of the processes in the example. Nickel powder is filled in and CO is supplied to reaction tower 10 and they react to obtain nickel carbonyl vapor. The nickel carbonyl vapor is introduced to condenser 12 and cooled to 38 degrees Celsius to make a nickel carbonyl liquid and then this fluid is sent to storage tank 14 for storage.

The nickel carbonyl fluid is removed form storage tank 14 and set to vaporizing chamber 16. The nickel carbonyl vapor and carrier gas CO18 are sent to deposition chamber 20. Mandrel 22 is placed on the bottom center of deposition chamber 20 and an adiabatic plate 24 seals the space between the inner walls of mandrel 22 and deposition chamber 20. A vaporized temperature for nickel carbonyl of over 38 degrees Celsius is maintained inside deposition chamber 20 and the temperature in the deposition chamber is chilled up to the temperature at which nickel carbonyl vapor decomposes; 148 degrees Celsius.

Mandrel 22 is constructed of an Al alloy metal wick 28 coated with heat resistant resin layer 26, and a heating pipe 32 provided inside metal wick 28 and oil warmed by heater 34 and circulated by pump 36 through heat pipe 32 and heat resistant resin layer 26 on the surface of mandrel 22 heated between 148 and 191 degrees Celsius, the temperature at which nickel carbonyl decomposes.

Un-reacted nickel carbonyl is in the exhaust from deposition chamber 20 so the gas is removed after the nickel carbonyl is recovered from exhaust gas condenser 38. The recovered nickel carbonyl is returned to storage tank 14.

Following is a description of an example of the manufactured plastic forming die used in the example apparatus comprising the above construction. Nickel powder is filled in and CO is supplied to reaction tower 10 and they react to obtain nickel carbonyl vapor. Then, the nickel carbonyl vapor is introduced to condenser 12 and cooled to 38 degrees Celsius to make a nickel carbonyl liquid which is sent to storage tank 14 for storage.

Mandrel 22 is placed on the bottom center of deposition chamber 20 and an adiabatic plate 24 seals the space between the inner walls of mandrel 22 and deposition chamber 20. A vaporized temperature for nickel carbonyl of over 38 degrees Celsius is maintained inside deposition chamber 20 and the temperature in the deposition chamber is chilled until it is no higher than 148 degrees Celsius, the temperature at which nickel carbonyl decomposes.

Mandrel 22 is comprised of an Al alloy metal wick 28 coated by a 10mm thick heat resistant resin layer, a 10mm copper heating pipe 32 provided inside this metal wick 28, oil warmed by heater 34 and circulated by pump 36 through heat pipe 32, and heat resistant resin layer 26 on the surface of mandrel 22 heated between 148 and 191 degrees Celsius, the temperature at which nickel carbonyl decomposes.

It then takes 16 hours for the vaporized nickel carbonyl and the carrier gas CO18 to be sent to deposition chamber 20 and for a 4mm nickel layer 40 to be deposited on the surface of mandrel 22. The unreacted nickel carbonyl contained in the exhaust gas from the deposition chamber 20 is removed after the nickel carbonyl is recovered from exhaust gas condenser 38.

Nickel layer 40 deposited on the surface of mandrel 22 is removed from deposition chamber 20 and heat resistant resin layer 26 is heated to a burning temperature, and nickel layer 40 can be easily peeled from mandrel 22 and, because the peeled nickel layer 40 was deposited evenly on the surface of mandrel 22, the plastic forming die can be used with almost no modifications. When the metal wick Al alloy is made with the same plastic die, the die can be reused.

### Example 2

Next, Diagram 2 shows mandrel 22 made by a heat, resistant resin layer which uses an electrical wire 42 imbedded inside the mandrel resulting from the heat resistant layer and, as in the above example, mandrel 22 is placed at the bottom center of deposition chamber 20 and the inner wall space between mandrel 22 and deposition chamber 20 is sealed with the adiabatic plate 24. The inside of deposition chamber 20 is maintained at a nickel carbonyl temperature of over 38 degrees Celsius and simultaneously the temperature of the inner walls of deposition chamber 20 are chilled so the temperature is not above 148 degrees Celsius, the temperature at which nickel carbonyl decomposes.

A current flows through electrical wire 42 and heats the surface of heat resistant resin layer 26 on mandrel 22 to between 149 and 191 degrees Celsius, the temperature at which nickel carbonyl decomposes, and the nickel carbonyl liquid removed from storage tank 14 is sent to vaporizing chamber 16 and both the vaporized nickel carbonyl and carrier gas CO18 are sent to deposition chamber 20 over a 12 hour period and a 3mm nickel layer is deposited on the surface of mandrel 22.

Mandrel 22 with nickel layer 40 deposited on its surface is removed form deposition chamber 20 and as the heat is increased to a temperature, at which heat resistant resin layer 26 burns, nickel layer 40 can be easily peeled from mandrel 22 and, since peeled nickel layer 40 was deposited evenly on the surface of mandrel 22, the plastic forming die can be used with almost no modifications.

### Example 3

On the surface of the Al alloy metal wick 28 used in Example 1 is covered a functional group of 2 epoxy resins with a heat resistant temperature of 150 degrees Celsius to form a 10mm thick heat resistant resin layer 26. This mandrel 22 is placed at the bottom center of deposition chamber 20 and the space between the inner walls of mandrel 22 and deposition chamber 20 is sealed by the adiabatic plate 24. Next, oil warmed by heater 34 is circulated by pump 36 through a 10mm copper pipe 32 set inside metal wick 28 and heat heat resistant resin layer 26 on the surface of mandrel 22 is heated to 148 - 191 degrees Celsius, the temperature at which nickel carbonyl decomposes but heat resistant resin layer 26 does not warp regardless of the increase in temperature.

Then, following the same method as shown in Example 1, a 4mm nickel layer 40 is deposited on the surface of mandrel 22. In comparison to the surface of the Al alloy metal wick 28 used in Example 1, in this example using a functional group of more than 3 epoxy resins with a heat resistant temperature of 250 degrees Celsius to form heat resistant resin layer 26 with a thickness of 10mm and a 4mm nickel layer 40 is deposited on the surface of mandrel 22 by the same method shown in Example 1.

Mandrel 22 on which surface nickel layer 40 is deposited in this or the reference example, is removed from deposition chamber 20 and heated to a temperature at which heat resistant resin layer 26 burns and nickel layer 40 is peeled from mandrel 22. However, in the reference example, heat resistant resin layer 26 hardens at 300 degrees Celsius and a temperature above 300 degrees Celsius is necessary for complete separation. However, the benefit of this invention is that heat resistant resin layer 26 in this example can be easily separated at 300 degrees Celsius.

### Example 4

Diagram 3 shows mandrel 22 with concave part 44 placed at the bottom center of deposition chamber 20 and ventilation blade 46 positioned on the axle so the air can blow toward concave part 44 of mandrel 22 and driven rotor 50 made of magnetic material fixed at the tip of axle 48. Rotation motor 52 is installed outside the wall of the deposition chamber separating it from driven rotor 50. Magnetic rotor 56 is installed on drive axle 54 of rotation motor 52 in the relative direction of the wall between it and driven rotor 50 and, when magnet rotor 56 rotates, driven rotor 50 rotates resulting in the rotation of rotation motor 52 and ventilation blade 46.

The apparatus used in this example can circulate the carbonyl vapor to the difficult part to circulate, so concave part 44 of mandrel 22 can get a sufficient supply of carbonyl vapor and the thickness of the nickel layer at the concave part 44 can be controlled by controlling the number of the rotation motor's rotations.

### Example 5

Diagram 4 shows mandrel 22 with two concave parts 44 placed at the bottom center of deposition chamber 20. Two vapor branch pipes 62 branch off from vapor supply branch 60 installed on the ceiling of the deposition chamber to supply carbonyl vapor and the tips of each vapor branch pipe are open and facing concave parts 44.

In this example, vaporized nickel carbonyl is sent with carrier gas CO18 by vapor supply pipe 60 to deposition chamber 20 and nickel carbonyl vapors are supplied to concave parts 44 on mandrel 22 where it is difficult for nickel carbonyl vapors to circulate, by two vapor branch pipes 62 from vapor supply pipe 60. Because of this, it is difficult for the carbonyl vapors to circulate and the concave part 44 of mandrel 22 can get a sufficient supply of carbonyl vapor.

The benefits of this invention for a manufacturing method for plastic forming dies as described above are the mandrel surface is heated to the metal carbonyl's deposition temperature and the metal carbonyl vapor degrades the mandrel surface by introducing a metal carbonyl vapor and a metallic layer is formed on the mandrel surface. The metal's deposition temperature from the metal carbonyl vapor is remarkably faster than temperatures from electro-casting. For example, it takes an Ni carbonyl one hour per 0.01 inches but compared to electro-casting Ni, this is 10 times faster and the productivity is remarkably higher. Also, metal deposition from metal carbonyl vapor is done evenly regardless of whether the mandrel shape is irregular so there is no need to make additional modifications after the plastic forming die is complete.

## Claims

1. A method of manufacturing plastic forming dies in which a mandrel is affixed to a surface in a sealed deposition chamber, the surface of said mandrel is heated to the metal carbonyl's deposition temperature, and a metallic layer forms on the surface of said mandrel by introducing metal carbonyl inside said deposition chamber.

2. A method of manufacturing plastic forming dies as claimed in Claim 1 in which said metal carbonyl is comprised of either Ni, Co, Ta or W.

3. A method of manufacturing plastic forming dies as claimed in Claim 2 in which a heat resistant resin layer comprised of alloy Al or Al forms on the surface of said mandrel.

4. A method of manufacturing plastic forming dies as claimed in Claim 3 in which oil circulates inside a heating pipe imbedded inside alloy Al or Al as the means for heating said mandrel.

5. A method of manufacturing plastic forming dies as claimed in Claim 3 in which a heating lamp is set at the back of alloy Al or Al as the means for heating said mandrel.

6. A method of manufacturing plastic forming dies as claimed in Claims 1 and 2 in which said mandrel is comprised of a heat resistant resin layer.

7. A method of manufacturing plastic forming dies as claimed in Claim 6 in which said mandrel is comprised of an electrical wire imbedded in said heat resistant layer.

8. A method of manufacturing plastic forming dies as claimed in Claim 1 employing a ventilation means which supplies a metal carbonyl vapor directed at a specific location on said mandrel.

9. A method of manufacturing plastic forming dies in which a mandrel is affixed to a surface in a sealed deposition chamber and said mandrel surface is heated to the metal carbonyl's deposition temperature and a metallic layer forms on said mandrel surface by introducing metal carbonyl inside said deposition chamber and, after a sprayed metal coating forms on the surface of said metallic layer, said sprayed metal coating is interposed as an internal back up metal.

10. A method of manufacturing plastic forming dies as in any of Claims 3 through 5 in which a heat resistant temperature of said heat resistant resin layer is under 150 degrees Celsius.

11. A method of manufacturing plastic forming dies as claimed in Claim 8 in which said ventilation means comprises a rotation motor set outside said deposition chamber and a ventilation blade set inside said deposition chamber which is rotated by said rotation motor.

12. A method of manufacturing plastic forming dies as claimed in Claim 8 in which said ventilation means is a vapor branching pipe to send carbonyl vapor from a vapor supply pipe.
